# EUROPEAN PATENT APPLICATION

(11) **EP 4 750 299 A1**
(43) Date of publication of application: **27.05.2026**
(21) Application number: 24215556.2
(22) Date of filing: 26.11.2024
(51) Int. Cl.: H10N 30/03, H10N 30/88, H10N 39/00

(54) **A PIEZOELECTRIC MODULE AND ITS ASSEMBLY METHOD**

(71) Applicant: Bergsonne Labs GmbH, 70569 Stuttgart (DE)
(72) Inventor: FIENE, Jonathan, 70569 Stuttgart (DE)
(74) Representative: Hofmann, Matthias

(57) **Abstract**

The present disclosure relates to a piezoelectric module and a method of assembly a piezoelectric module. The piezoelectric module includes a piezoelectric unit; a circuit unit, wherein the circuit unit is connected to the piezoelectric unit; a connector configured to electronically connect to one or more external electronic components, wherein the connector is connected to the circuit unit; and an insulate housing configured to integrate the piezoelectric unit and the circuit unit, wherein the insulate housing accommodates the piezoelectric unit, the circuit unit and a part of the connector.

## Description

### TECHNICAL FIELD

The present disclosure generally relates to a piezoelectric module and a method of assembly a piezoelectric module.

### BACKGROUND

To date, piezoelectric actuators for haptic-feedback applications have only been integrated into a limited number of products where the actuator and the drive electronics have been separately designed. For example, TDK has developed the PowerHap piezoelectric actuators with capabilities for many applications, but they require complex drive electronics (which needs to provide high voltages) and precise mechanical mounting. However, it is often problematic to integrate the piezoelectric actuator into an electronic system. Known systems often require complex assembly processes that can be time-consuming, cost-intensive and prone to errors. There is an urgent need to improve reliability and flexibility in applications of the piezoelectric components.

### SUMMARY

According to a first aspect of the present disclosure, a piezoelectric module includes a piezoelectric unit, a circuit unit, a connector, and an insulate housing. The circuit unit is connected to the piezoelectric unit. The connector is configured to electronically connect to one or more external electronic components. The connector is connected to the circuit unit. The insulate housing is configured to integrate the piezoelectric unit and the circuit unit. The insulate housing accommodates the piezoelectric unit, the circuit unit and a part of the connector.

In some embodiments, the piezoelectric unit utilizes the piezoelectric effect. The piezoelectric effect is a property of certain materials (quartz, Rochelle salt, and various ceramics like lead zirconate titanate (PZT)) that allows them to generate an electric charge in response to applied mechanical stress. This effect is reversible, meaning that these materials can also deform mechanically when an electric field is applied to them. The piezoelectric unit can perform these two types of piezoelectric effects. In other words, the piezoelectric unit can perform different functions in different applications. For example, in some applications, the piezoelectric unit can act as a sensor to detect force or pressure, while in other applications it can act as an actuator to achieve precise motion control.

In some embodiments, the circuit unit is connected to the piezoelectric unit and enables effective operations of the piezoelectric unit. The circuit unit can process electrical signals generated by the piezoelectric unit. For example, when the piezoelectric unit acts as a sensor, the circuit unit may amplify, filter, and condition the electrical signals produced by the piezoelectric material in response to mechanical stress. The circuit unit can also be responsible for acquiring and/or measuring data from the sensor. It may include analog-to-digital converters (ADCs) to digitize the analog signals from the sensors for further processing and analysis. In the case of piezoelectric actuators, the circuit unit can provide the necessary electrical drive signals to control the actuator's movement. This involves generating and regulating the voltage and current applied to the piezoelectric material to achieve the desired mechanical deformation. In systems that require precise control, the circuit unit may include feedback mechanisms to monitor the performance of the piezoelectric elements. For example, it can continuously monitor the output of a piezoelectric sensor and adjust the drive signals to a piezoelectric actuator to maintain desired performance. The circuit unit may also handle power management functions, ensuring that the piezoelectric elements receive stable and appropriate power for their operation. This can include voltage regulation and protection against overvoltage or overcurrent conditions. In more complex systems, the circuit unit may facilitate communication with other components or systems. This can involve transmitting data to a central controller, user interface, or external devices for monitoring and control purposes.

In some embodiments, the connector connects to one or more external electronic components and the circuit unit. The connector can establish a reliable electrical connection between the piezoelectric module and the external electronic components. This allows the transfer of electrical signals or power from one to another. High-quality connectors can be used to maintain signal integrity by minimizing signal loss, interference, and crosstalk. The connector can facilitate easy assembly and disassembly of the piezoelectric module. With the connector, the piezoelectric module can be quickly and easily connected electronically or disconnected with other electronic components. External electronic components that can be connected to a piezoelectric module via a connector can vary widely depending on the specific application and system requirements. For example, external electronic components include but are not limited to: microcontrollers and microprocessors, signal processing units, power supply units, communication interfaces, display units, data acquisition systems, control systems, computers and embedded systems, wireless communication modules, actuators and motors, sensors, user interface devices, or any combination thereof.

In some embodiments, the piezoelectric unit and the circuit unit are integrated within the insulate housing. The insulate housing can provide electrical insulation. Such insulation can ensure that the piezoelectric unit, circuit unit and other internal components operate safely and reliably without unintended electrical interference. The insulate housing can protect the internal components from physical damage due to mechanical shocks, vibrations, or impacts. It may provide a robust enclosure that shields sensitive electronic parts from external mechanical forces. The insulate housing can protect the internal components from environmental factors such as dust, moisture, humidity, and temperature variations. It can maintain the performance and longevity of the piezoelectric module in various operating conditions. The insulate housing can provide structural support and alignment for the internal components. It ensures that the piezoelectric unit, circuit unit, and connector are securely held in place and properly aligned, which can ensure the module's overall functionality and reliability.

The piezoelectric module is a fully integrated "plug and play" module which encloses the piezoelectric unit and circuit unit into a single package with a standard low-voltage interface and convenient mechanical mounting affordances.

In an implementation of the first aspect, the insulate housing may be replaceable. For example, a user can change part or all of the insulate housing. The insulate housing can be partially or completely removed and easily replaced with a new one. This makes maintenance and repairs simpler and more cost-effective. In addition, the replaceable insulate housing makes it possible to adjust size of the piezoelectric module based on applications. In some embodiments, the user can change the size, especially the thickness of the insulate housing, to compensate for the tolerance of its piezoelectric unit. Specifically, the tolerance refers to the allowable variations in the dimensions of the piezoelectric unit due to manufacturing processes. By adjusting the size and thickness of the insulate housing, users can compensate for these variations, ensuring that the piezoelectric unit is properly enclosed and supported within the housing.

In an implementation of the first aspect, the insulate housing may include a board. The piezoelectric unit may be connected to a first side of the board, and the circuit unit may be located on a second side of the board and is connected to the piezoelectric unit through the board. The piezoelectric unit and the circuit unit can be mounted on opposite sides of the board inside the insulating housing. The board can ensure stable installation of the piezoelectric unit and the circuit unit, maintain effective connections between them, and provide reliable mechanical support to the piezoelectric module.

In an implementation of the first aspect, the insulate housing may include a faceplate and an insulate layer. The faceplate may be connected to the board to cover the first side of the board and the piezoelectric unit. The insulate layer may be configured to cover the second side of the board, the circuit unit and the part of the connector. After mounting the piezoelectric unit and the circuit unit on the board, the faceplate and the insulate layer can be used to encapsulate the piezoelectric module.

In an implementation of the first aspect, the thickness of the insulate housing may be adjustable by replacing faceplates with different thicknesses. The use of different thickness faceplates can compensate for the tolerance of the piezoelectric unit. For example, TDK Corporation specifies the thickness tolerance of +/-80µm for its PowerHap actuators. However, these actuators have an actuation range of only approximately 20µm. This significant discrepancy makes direct integration of the actuator into hardware quite challenging and often necessitates either spring-based preloading or individual qualification of each actuator. This issue can be addressed by using faceplates in increments of approximately 5µm, allowing the user to achieve an overall piezoelectric module tolerance that is within the actuator's actuation range.

In an implementation of the first aspect, the faceplate can be manufactured by 3D printing, rapid prototyping, injection molding, and/or CNC machining. In some embodiments, the user can change the faceplate easily with 3D printing, rapid prototyping or the like to achieve the mounting affordance.

In an implementation of the first aspect, the insulate layer may be made of non-conductive epoxy, polyurethane, acrylic resin and/or polyimide. In some embodiments, one surface of the piezoelectric module (corresponding to the second side of the board) can be filled with these non-conductive materials. The insulate layer can be formed after curing these non-conductive materials. Except the part of the connecter inside the piezoelectric module, the other part of the connect can extend through the insulate layer.

In an implementation of the first aspect, the piezoelectric module may include one or more mounting features configured to mechanically connect to one or more external devices. Mounting features can allow the piezoelectric module to be used in a variety of settings and with different types of external devices. Furthermore, mounting features can simplify the installation process and contribute to the structural stability of the piezoelectric module when it is connected to external device.

In an implementation of the first aspect, the one or more mounting features may include any of a hole, a flange, a slot, and/or a bracket. The mounting features can vary in design and functionality, providing different methods of mounting the piezoelectric module.

In an implementation of the first aspect, the piezoelectric unit can act as a piezoelectric actuator and/or a force sensor, wherein the circuit unit can be configured to activate the piezoelectric actuator and/or read values of the force sensor. Alternatively, a voltage range supplying the piezoelectric module is 3 to 5 V, and/or a power draw of the piezoelectric module is 10 to 80 mA, and/or the piezoelectric module communicates via I2C (Inter-Integrated Circuit)/I3C (Improved Inter-Integrated Circuit) interface. The piezoelectric actuator can convert electrical energy into precise mechanical movement. The force sensor can convert applied force into an electrical signal.

In an implementation of the first aspect, the connector may include four pins which are power pin, ground pin, SCL pin and SDA pin. The pins can be physical and electrical connection points on the connector. They can be used to interface with other external electrical components, providing pathways for electrical signals or power. Each pin may typically have a specific function. The power pin can supply the necessary voltage to power the piezoelectric module. The ground pin can provide a common return path for the electrical current, ensuring the circuit is complete. The SCL (Serial Clock Line) pin can be used for the clock line, which can synchronize the data transfer between devices. For example, the SCL pin can carry the clock signal generated by the master device to synchronize data transfer between the master and slave devices. The clock signal ensures that data is transferred at the correct timing intervals, allowing multiple devices to communicate over the same data line without interference. The SDA (Serial Data Line) pin can be used for the data line, which carries the data between devices. For example, Both the master and slave devices can send and receive data through this line. The data transfer on the SDA line is synchronized with the clock signal on the SCL line, ensuring accurate and reliable communication.

In an implementation of the first aspect, the connector may include one or more additional pins. The one or more additional pins may include any of a separate digital-I/O power pin, and/or a configurable GPIO pin that can be configured to transfer interrupt alerts and/or trigger events between the piezoelectric module and a host processor. In some embodiments, the separate digital-I/O power pin can provide a dedicated power supply for digital input/output (I/O) operations, separate from the main power supply. By having a separate power pin for digital I/O, the module can ensure stable and reliable power for digital signals, which can be crucial for maintaining signal integrity and reducing noise in digital communication. In some embodiments, the configurable GPIO (General-Purpose Input/Output) pin can be configured for various input or output functions, providing flexibility in how the module interacts with other devices. The GPIO pin can be programmed to perform different tasks. In one example, the GPIO pin can be used to send interrupt signals from the piezoelectric module to the host processor. Interrupt alerts can notify the processor of specific events or conditions that require immediate attention, allowing for responsive and efficient handling of tasks. In another example, the GPIO pin can also be used to trigger events between the piezoelectric module and the host processor. For example, it can initiate specific actions or processes in response to certain conditions or inputs, facilitating coordinated operation between the module and the processor.

As illustrated above, the piezoelectric module of the first aspect can combine the tiny actuator with the drive electronics into a single, closed package with mechanical affordances for simple physical integration and a low-voltage, industry-standard digital communications interface that will make the module "plug and play" capable.

According to a second aspect of the present disclosure, a method of assembly of a piezoelectric module includes: mounting a piezoelectric unit into an insulate housing, wherein the insulate housing is in an open status; connecting a circuit unit to the piezoelectric unit, wherein the circuit unit connects to a connector, and wherein the connector is configured to electronically connect to one or more external electronic components; and closing the insulate housing so that the insulate housing in a closed status accommodates the piezoelectric unit, the circuit unit and a part of the connector.

In some embodiments, the open status refers to the situation that the insulate housing is not yet encapsulated or not yet assembled. The closed status refers to another situation that the insulate housing is already assembled or encapsulated.

In an implementation of the second aspect, the method further includes: connecting the piezoelectric unit to a first side of a board of the insulate housing; locating the circuit unit on a second side of the board of the insulate housing; and connecting the circuit unit to the piezoelectric unit through the board.

In an implementation of the second aspect, the method further includes: filling the second side of the board with non-conductive materials to cover the second side of the board, the circuit unit and the part of the connector; and connecting a faceplate to the board of the insulate housing to cover the first side of the board and the piezoelectric unit.

The method can package the electronics into an area that is the same size or smaller than a normal piezoelectric element, without needing to compromise performance. This advancement has been facilitated by advanced integrated circuits (ICs) and miniaturized passive components. Additionally, flexible circuit fabrication techniques can enable the reliable assembly of these components at a relatively low cost.

Additional features will be set forth in part in the description which follows, and in part will become apparent to those skilled in the art upon examination of the following and the accompanying drawings or may be learned by production or operation of the examples. The features of the present disclosure may be realized and attained by practice or use of various aspects of the methodologies, instrumentalities, and combinations set forth in the detailed examples discussed below.

### BRIEF DESCRIPTION OF THE DRAWINGS

The present disclosure is further described in terms of exemplary embodiments. These exemplary embodiments are described in detail with reference to the drawings. The drawings are not drawn to scale. These embodiments are non-limiting exemplary embodiments, in which like reference numerals represent similar structures throughout the several views of the drawings, and wherein:
FIG. 1 is a schematic diagram of an exemplary piezoelectric module 100 according to some embodiments of the present disclosure.
FIG. 2 is a schematic diagram illustrating a perspective view of an exemplary piezoelectric module 200 according to some embodiments of the present disclosure.
FIG. 3 is a schematic diagram illustrating an exploded view of an exemplary piezoelectric module 300 according to some embodiments of the present disclosure.
FIGs. 4a to 4d are flowcharts illustrating an assembly process of an exemplary piezoelectric module according to some embodiments of the present disclosure.
FIGs. 5a to 5c are schematic diagrams illustrating cross sectional views of an exemplary piezoelectric module 500 according to some embodiments of the present disclosure.
FIG. 6 is a schematic diagram illustrating multiple exemplary piezoelectric modules according to some embodiments of the present disclosure.

### DETAILED DESCRIPTION

The following description is presented to enable any person skilled in the art to make and use the present disclosure and is provided in the context of a particular application and its requirements. Various modifications to the disclosed embodiments will be readily apparent to those skilled in the art, and the general principles defined herein may be applied to other embodiments and applications without departing from the spirit and scope of the present disclosure. Thus, the present disclosure is not limited to the embodiments shown but is to be accorded the widest scope consistent with the claims.

The terminology used herein is for the purpose of describing particular example embodiments only and is not intended to be limiting. As used herein, the singular forms "a", "an", and "the" may be intended to include the plural forms as well, unless the context clearly indicates otherwise. It will be further understood that the terms "comprise", "comprises", and/or "comprising", "include", "includes", and/or "including", when used in this specification, specify the presence of stated features, integers, steps, operations, elements, and/or components, but do not preclude the presence or addition of one or more other features, integers, steps, operations, elements, components, and/or groups thereof.

These and other features, and characteristics of the present disclosure, as well as the methods of operation and functions of the related elements of structure and the combination of portions and economies of manufacture, may become more apparent upon consideration of the following description with reference to the accompanying drawings, all of which form a part of this disclosure. It is to be expressly understood, however, that the drawings are for the purpose of illustration and description only and are not intended to limit the scope of the present disclosure. It is understood that the drawings are not to scale.

The flowcharts used in the present disclosure illustrate operations that systems implement according to some embodiments of the present disclosure. It is to be expressly understood, the operations of the flowchart may be implemented not in order. Conversely, the operations may be implemented in inverted order, or simultaneously. Moreover, one or more other operations may be added to the flowcharts. One or more operations may be removed from the flowcharts.

In order to make the purpose, technical solution, and advantages of the present disclosure clearer, the present disclosure will be further described in detail below with reference to the accompanying drawings and embodiments. It should be understood that the specific embodiments described herein are merely illustrative of the present disclosure and are not intended to limit the present disclosure.

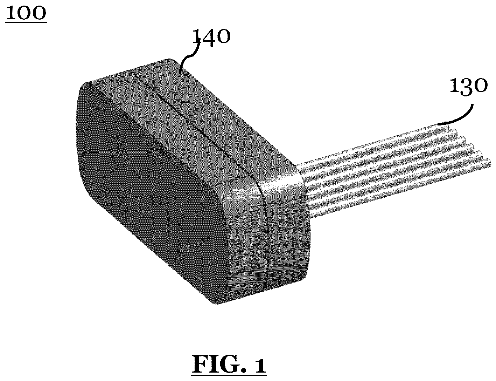

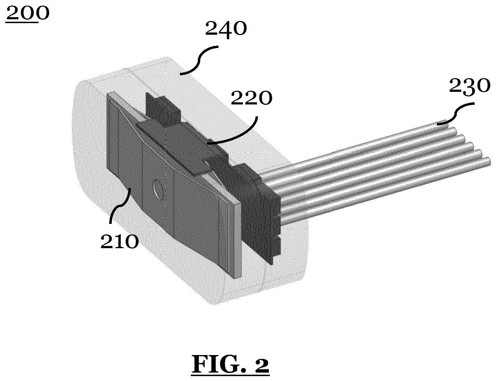

FIG. 1 is a schematic diagram of an exemplary piezoelectric module 100 according to some embodiments of the present disclosure. The piezoelectric module 100 (also named "TAK") is miniature fully-integrated high-bandwidth piezo modules. The piezoelectric unit and the circuit unit are enclosed in the insulate housing 140. The insulate 140 is designed to provide insulation and protection for the internal circuitry and piezoelectric unit. The insulate housing 140 is shown to encapsulate the internal components, ensuring that they are securely held in place and protected from external environmental factors. The design of the housing 140 also allows for ease of assembly and disassembly, which is beneficial for maintenance and replacement purposes. The overall structure of the piezoelectric module 100, as depicted in Figure 1, highlights the compact and integrated nature of the device, making it suitable for various applications where space and reliability are critical. The connector 130 connects to the circuit unit and extends through the insulate housing 140, facilitating the integration of the piezoelectric module 100 into a larger electronic system. The perspective view of the piezoelectric module is explained in detail in FIG. 2.

In some embodiments, the insulate housing 140 can be replaceable or adjustable. In one example, any part or all of the insulate housing 140 can be removed or replaced. In another example, the user can change or manufacture the insulate housing 140 easily with 3D printing, rapid prototyping, injection molding, CNC machining or the like. The materials used for the insulate housing 140 can include non-conductive materials.

In some embodiments, the insulate housing 140 can be provided with one or more mounting features to achieve mechanical connection with other external devices. The one or more mounting features may include but not limited to any of a hole, a flange, a slot, and/or a bracket.

In some embodiments, the piezoelectric unit may be the PowerHap piezoelectric actuator. The TDK Corporation has developed the PowerHap piezoelectric actuators with capabilities for many applications, but they require complex drive electronics (including high voltages) and precise mechanical mounting. At the same time, Boreas Technologies has developed a compact, high-efficiency piezo-driver IC that can be used to interface a TDK piezo actuator to standard embedded electronics (Arduino, etc.). However, to use this pair of products, the user needs to possess significant technical expertise for solving two fundamental challenges:
a) precisely mount the piezo actuator into a mechanical assembly, where the actuator does not include any mounting features and the displacement (20-40 microns) is in fact less than the overall tolerance of the PowerHap (80 microns);
b) design and fabricate the circuitry to interface all of the components, including flexible elements for connection to the PowerHap and microelectronics for the Boreas driver IC, which includes both high output voltages (up to +/-90V) and high intermediate currents (up to 1.3A).
The TAK project can solve these challenges with a fully-integrated "plug and play" module which encloses the PowerHap and drive electronics into a single package with a standard low-voltage interface and convenient mechanical mounting affordances. The salient benefits to the end user can include one or more of:
a) low-voltage "plug-and-play" interface for easy operation with standard microcontrollers (Arduino, etc.);
b) mechanical features for simple mounting and assembly;
c) tightly controlled tolerances (removing the PowerHap displacement-to-tolerance problem);
d) containment of the high voltages and currents (eventual potential for Class 1 certification for use in other products).

Embodiments of the piezoelectric module can achieve the following features:
- Vibratory output
   ∘ wide (10-400+ Hz) bandwidth
   ∘ 40 micron displacement
   ∘ 4N blocking force
- Force sensing
   ∘ ~5 gram sensitivity
- Low-voltage "plug and play" digital interface
   ∘ 3-5V supply
   ∘ 10-80mA power draw
   ∘ I2C / I3C interface (with programmable addressing)
- "Class 1" containment of high voltages
- multiple mechanical mounting options

In an embodiment, a piezoelectric module combines both the physical piezoelectric unit (such as an actuator) and the circuit unit (such as drive electronics) into a single unit that does not require external circuitry. The solution proposed here is to combine the piezoelectric unit (such as a tiny actuator) with the circuit unit (such as the drive electronics) into a single, closed package with mechanical affordances for simple physical integration and a low-voltage, industry-standard digital communications interface that can make the module "plug and play" capable. By encapsulating the components together into a single module, it is possible to fully isolate the high voltages necessary to activate the piezoelectric crystal, thereby making it possible to utilize this technology in areas where it was previously prevented or considered impossible. Such integration can be achieved due to advanced ICs and miniaturized passive components, together with better flexible circuit fabrication techniques making it possible to assemble these with high reliability at relative low cost. Comparing to the state of the art in piezoelectric actuation for haptics, one finds exactly the components that are being integrated into this design, namely the PowerHap actuator from TDK and the BOS1921 piezoelectric driver IC from Boreas Technologies. In the state of the art, these components need to be carefully integrated into a larger system along with a number of other required elements. The other required elements are mostly passive electrical components (a number of capacitors, a high-current inductor, etc.). The TAK piezoelectric module of the present disclosure provides a "plug and play" solution without needing other elements to integrate into a large electronic system.

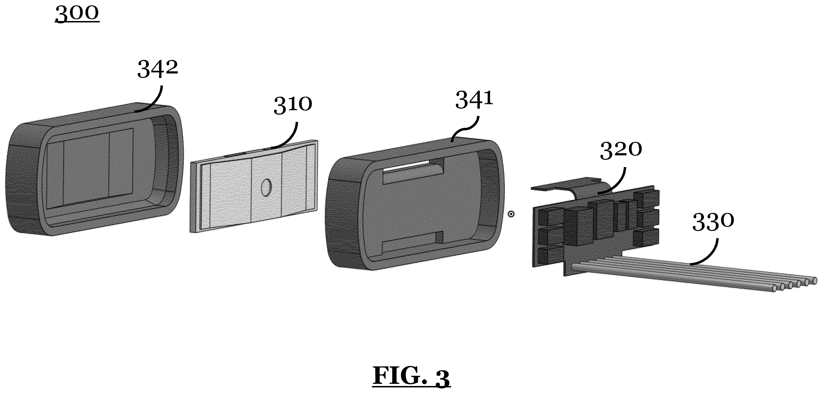

FIG. 2 is a schematic diagram illustrating a perspective view of an exemplary piezoelectric module 200 according to some embodiments of the present disclosure. The piezoelectric module 200 comprises a piezoelectric unit 210, a circuit unit 220, a connector 230, and an insulate housing 240. The piezoelectric unit 210 is integrated within the insulate housing 240, which is designed to accommodate and protect the internal components of the module. The circuit unit 220 is connected to the piezoelectric unit 210 and is also housed within the insulate housing 240. The connector 230 extends from the circuit unit 220 and is configured to electronically connect the piezoelectric module 200 to one or more external electronic components. The exploded view of the piezoelectric module is explained in detail in FIG.3.

In some embodiments, the connector 230, which extends from the circuit unit 220, comprises multiple pins that facilitate the electronic connection to external electronic components. These pins are likely designated for power, ground, and communication signals, enabling the module to interface with other electronic systems. In some examples, the connector may include other additional pins such as a separate digital-I/O power pin, and/or a configurable GPIO pin. The insulate housing 240 is designed to accommodate a part of the connector 230, ensuring that the connection points between the connector 230 and the circuit 220 are protected and insulated from external environmental factors.

Overall, Figure 2 illustrates the structural and functional integration of the piezoelectric unit 210, circuit unit 220, connector 230, and insulate housing 240 within the piezoelectric module 200. The design ensures that the module is compact, protected, and capable of interfacing with external electronic components, making it suitable for various applications where piezoelectric actuation or sensing is required.

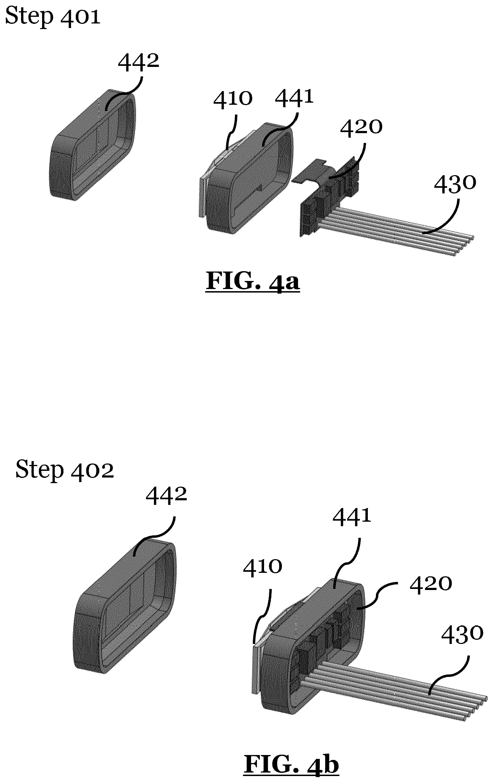

FIG. 3 is a schematic diagram illustrating an exploded view of an exemplary piezoelectric module 300 according to some embodiments of the present disclosure. The module comprises a piezoelectric unit 310, a circuit unit 320, a connector 330, and an insulate housing. The insulate housing can include a board 341 (also named as backplane) and a faceplate 342. The assembly process of the piezoelectric module is explained in detail in FIGs. 4a to 4d.

In some embodiments, the piezoelectric unit 310 can be a piezoelectric actuator or a force sensor. The piezoelectric unit 310 is designed to convert mechanical energy into electrical energy or vice versa, depending on its application as either a sensor or an actuator.

In some embodiments, the circuit unit 310 can be a printed circuit board PCB with multiple electronic components mounted on it. These components may include various integrated circuits, resistors, capacitors, and possibly other passive and active elements necessary for the operation of the piezoelectric module. The circuit unit 320 is able to process the signals generated by the piezoelectric unit 310 and to interface with external electronic components through the connector 330. As previously discussed, the circuit unit 320 is a crucial component that enables the effective operation of the piezoelectric module 300 by managing the electrical signals, providing control and drive functions, and ensuring proper data acquisition and communication.

In some embodiments, the insulate housing may include a board 341 and a faceplate 342. The board 340 can have a recessed area to accommodate the circuit unit 320 and the part of the connector 330, ensuring that these components are securely held in place. The faceplate 342 can similarly have a recessed area to house the piezoelectric unit 310, providing structural support and insulation. In some examples, the recessed area of the board can be filled with non-conductive materials to achieve a complete encapsulation of the piezoelectric module 330.

This configuration ensures that the piezoelectric module 300 is compact, robust, and capable of being integrated into various electronic systems. The insulate housing provides mechanical protection and electrical insulation, while the connector 330 allows for easy interfacing with other electronic components. The modular design also facilitates the replacement of individual components, such as the faceplate 342, to accommodate different application requirements or to perform maintenance and repairs.

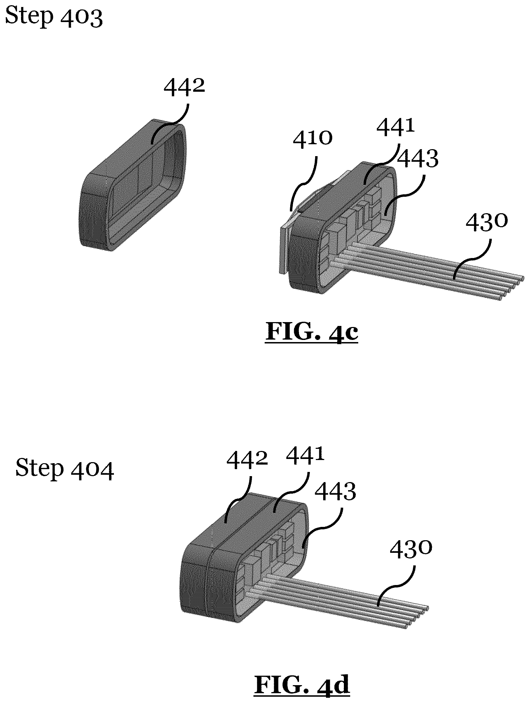

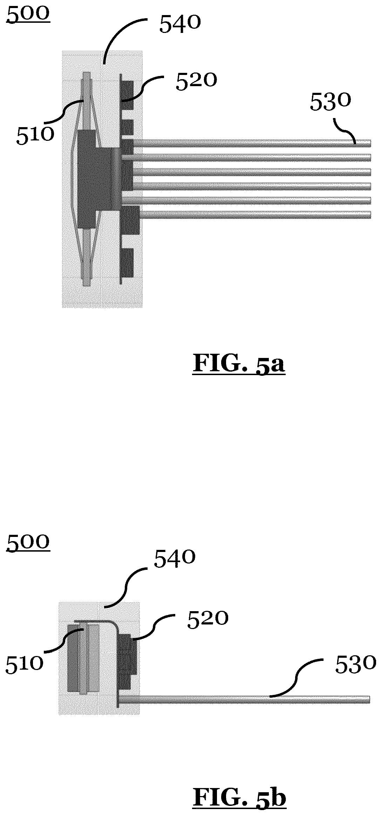

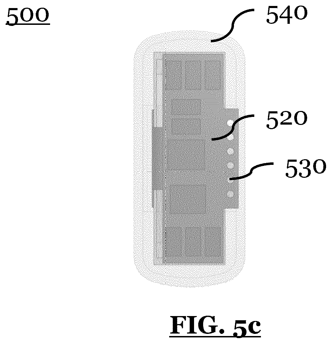

FIGs. 4a to 4d are flowcharts illustrating an assembly process of an exemplary piezoelectric module according to some embodiments of the present disclosure. In step 401 shown in FIG.4a, the piezoelectric unit 410 can be adhered to the front of the backplane 441. In step 402 shown in FIG.4b, the circuit unit 420 can be inserted through the backplane 441 and soldered to the piezoelectric unit 410. In step 403 shown in FIG.4c, the backplane 441 void can be filled with non-conductive epoxy to form a insulate layer 443. From steps 401 to 403, the insulate housing of the piezoelectric module is in an open status. In the open status, the assembly is not completed and some components are exposed. In step 404 shown in FIG. 4d, the backplane 441 + the piezoelectric unit 410 assembly thickness can be measured and the desired-thickness faceplate 442 can be adhered to the front of the piezoelectric unit 410. In step 404, the insulate housing is encapsulated so that it is in a closed status. In the closed status, the insulate housing accommodates the piezoelectric unit 410, the circuit unit 420 and a part of the connector 430. The cross-sectional views of the piezoelectric module is explained in detail in FIGs. 5a to 5c.

In some embodiments, the user can use different thickness faceplates to compensate for the tolerance of the actuators. For example, TDK specifies +/-80µm for the thickness of the PowerHap, yet they only have a ~20µm actuation range - this makes bare integration of the actuator into hardware quite challenging (and often requires either spring-based preloading or qualification of each actuator). The user can use faceplates in ~5µm increments so that an overall TAK module tolerance can be below the actuation range.

It should be noted that the connection method between different components includes but not limited to adhered connection, soldered connection, press-fit connection, or the like. In some embodiments, the insulate layer 443 can be made of materials including but not limited to non-conductive epoxy, polyurethane, acrylic resin and/or polyimide, or any combination thereof. In summary, FIGs. 4a to 4d illustrate the assembly process and the structural configuration of the piezoelectric module, highlighting its flexibility.

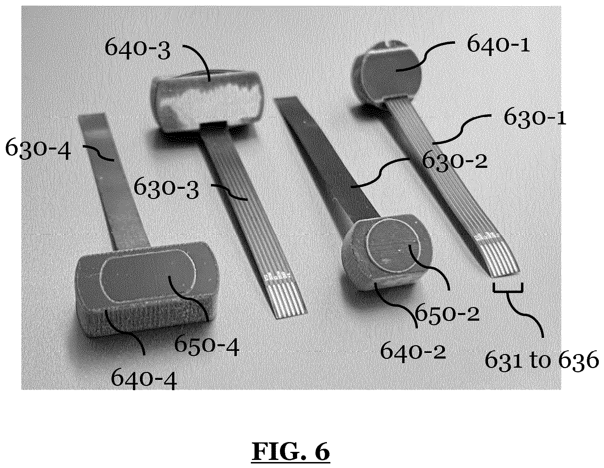

FIGs. 5a to 5c are schematic diagrams illustrating cross sectional views of an exemplary piezoelectric module 500 according to some embodiments of the present disclosure. The piezoelectric module 500 includes the piezoelectric unit 510, the circuit unit 520, the connector 530 and the insulate housing 540. Specifically, FIG. 5a is a top view, FIG. 5b is a side view and FIG. 3 is a front view of the piezoelectric module 500 in the closed status. The exterior appearance of the piezoelectric module is explained in detail in FIG.6.

FIG. 6 is a schematic diagram illustrating multiple exemplary piezoelectric modules according to some embodiments of the present disclosure. There are four piezoelectric modules shown in FIG. 6. The insulate housing 640-1 to 640-4 are various in these four piezoelectric modules. The connector 630-1 to 630-4 may include multiple pins 631 to 636. Some piezoelectric modules may include buttons 650-2 and 650-4 on the insulate housings 640-2 and 640-4.

In some embodiments, the connectors 630-1 to 630-4 may have a minimum of four pins (e.g., power, ground, SCL, SDA). furthermore, the connectors 630-1 to 630-4 may have the other two pins providing additional functionality. The other two pins may be a separate digital-I/O power pin and a configurable GPIO pin that can be used to transfer interrupt alerts and/or trigger events between the module and the host processor.

In some embodiments, the buttons 650-2 and 650-4 can provide user interaction capabilities for the piezoelectric modules. In one example, these buttons allow users to manually control or activate the piezoelectric actuator, enhancing the module's functionality and usability in various applications. In another example, these buttons can enhance the usability and functionality of the force sensor, allowing users to perform operations such as pressing the button, interact with the sensor, and ensure accurate and reliable force measurements. The buttons 650-2 and 650-4 are integrated into the insulate housing 640-2 and 640-4, ensuring they are protected and easily accessible for user operation.

It should be noted that the exterior appearance of the piezoelectric module is not limited to those shown in FIG. 6. Except this "pill" design, there are other designs with flanges, holes, etc to enhance particular affordances for mechanical mounting. The mounting affordances can be very easy to change with 3D printing/rapid prototyping.

In some embodiments, the piezoelectric module is capable of delivering a vibratory output with a wide bandwidth ranging from 10 Hz to over 400 Hz, achieving a displacement of 40 microns and a blocking force of 4 Newtons. Additionally, the module features advanced force sensing with a sensitivity of approximately 5 grams, enabling accurate detection of applied forces. The module is equipped with a low-voltage "plug and play" digital interface, operating within a supply range of 3 to 5 volts and drawing power between 10 to 80 milliamps. This interface supports I2C and I3C communication protocols with programmable addressing, facilitating seamless integration with various control systems. Further enhancements of the module include "Class 1" containment of high voltages to ensure safety and compliance with regulatory standards, as well as multiple mechanical mounting options to accommodate diverse installation requirements. Furthermore, "Class 1" containment of high voltages may include but not limit to the use of technical means such as insulating materials, isolation transformers, opto-couplers, shields and earth protection to ensure electrical isolation and protection of the high voltage parts from the low voltage parts, other parts of the circuit boards and user-accessible parts to protect the user and the operator. These features collectively make the piezoelectric module a robust and adaptable solution for a wide range of applications.

Overall, the piezoelectric module of the present disclosure provides an "off the shelf' or "plug and play" solution that combines both the piezoelectric unit (such as the physical actuator) and the circuit unit (such as the drive electronics) into a single unit that does not require external circuitry.

It should be noted that the above description is merely provided for the purposes of illustration, and not intended to limit the scope of the present disclosure. For persons having ordinary skill in the art, multiple variations and modifications may be made under the teachings of the present disclosure. However, those variations and modifications do not depart from the scope of the present disclosure.

Having thus described the basic concepts, it may be rather apparent to those skilled in the art after reading this detailed disclosure that the foregoing detailed disclosure is intended to be presented by way of example only and is not limiting. Various alterations, improvements, and modifications may occur and are intended to those skilled in the art, though not expressly stated herein. These alterations, improvements, and modifications are intended to be suggested by this disclosure, and are within the spirit and scope of the exemplary embodiments of this disclosure.

Moreover, certain terminology has been used to describe embodiments of the present disclosure. For example, the terms "one embodiment," "an embodiment," and/or "some embodiments" mean that a particular feature, structure or characteristic described in connection with the embodiment is included in at least one embodiment of the present disclosure. Therefore, it is emphasized and should be appreciated that two or more references to "an embodiment" or "one embodiment" or "an alternative embodiment" in various portions of this specification are not necessarily all referring to the same embodiment. Furthermore, the particular features, structures or characteristics may be combined as suitable in one or more embodiments of the present disclosure.

Further, it will be appreciated by one skilled in the art, aspects of the present disclosure may be illustrated and described herein in any of a number of patentable classes or context including any new and useful process, machine, manufacture, or composition of matter, or any new and useful improvement thereof. Accordingly, aspects of the present disclosure may be implemented entirely hardware, entirely software (including firmware, resident software, micro-code, etc.) or combining software and hardware implementation that may all generally be referred to herein as a "unit," "module," or "system."

Furthermore, the recited order of processing elements or sequences, or the use of numbers, letters, or other designations therefore, is not intended to limit the claimed processes and methods to any order except as may be specified in the claims. Although the above disclosure discusses through various examples what is currently considered to be a variety of useful embodiments of the disclosure, it is to be understood that such detail is solely for that purpose, and that the appended claims are not limited to the disclosed embodiments, but, on the contrary, are intended to cover modifications and equivalent arrangements that are within the spirit and scope of the disclosed embodiments.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. This method of disclosure, however, is not to be interpreted as reflecting an intention that the claimed subject matter requires more features than are expressly recited in each claim. Rather, claimed subject matter may lie in less than all features of a single foregoing disclosed embodiment.

## Claims

1. A piezoelectric module, comprising:
a piezoelectric unit;
a circuit unit connected to the piezoelectric unit;
a connector configured to electronically connect to one or more external electronic components, wherein the connector is connected to the circuit unit; and
an insulate housing configured to integrate the piezoelectric unit and the circuit unit, wherein the insulate housing accommodates the piezoelectric unit, the circuit unit and a part of the connector.

2. The piezoelectric module of claim 1, wherein the insulate housing is replaceable.

3. The piezoelectric module of claims 1 or 2, wherein the insulate housing comprises a board, the piezoelectric unit is connected to a first side of the board, and the circuit unit is located on a second side of the board and is connected to the piezoelectric unit through the board.

4. The piezoelectric module of claim 3, wherein the insulate housing comprises a faceplate and an insulate layer, wherein the faceplate is connected to the board to cover the first side of the board and the piezoelectric unit and the insulate layer is configured to cover the second side of the board, the circuit unit and the part of the connector.

5. The piezoelectric module of claim 4, wherein a thickness of the insulate housing is adjustable by replacing faceplates with different thicknesses.

6. The piezoelectric module of claims 4 or 5, wherein the faceplate is manufactured by 3D printing, rapid prototyping, injection molding, and/or CNC machining.

7. The piezoelectric module of any of claims 4 to 6, wherein the insulate layer is made of non-conductive epoxy, polyurethane, acrylic resin and/or polyimide.

8. The piezoelectric module of any of claims 1 to 7, further comprising:
one or more mounting features configured to mechanically connect to one or more external devices.

9. The piezoelectric module of claim 8, wherein the one or more mounting features comprise any of a hole, a flange, a slot, and/or a bracket.

10. The piezoelectric module of any of claims 1 to 9, wherein the piezoelectric unit acts as a piezoelectric actuator and/or a force sensor, wherein the circuit unit is configured to activate the piezoelectric actuator and/or read values of the force sensor; or
a voltage range supplying the piezoelectric module is 3 to 5 V, and/or a power draw of the piezoelectric module is 10 to 80 mA, and/or the piezoelectric module communicates via I2C/I3C interface.

11. The piezoelectric module of any of claims 1 to 10, wherein the connector comprises four pins which are power pin, ground pin, SCL pin and SDA pin.

12. The piezoelectric module of claim 11, wherein the connector comprises one or more additional pins which comprises any of a separate digital-I/O power pin, and/or a configurable GPIO pin that is configured to transfer interrupt alerts and/or trigger events between the piezoelectric module and a host processor.

13. A method of assembly a piezoelectric module, comprising:
mounting a piezoelectric unit into an insulate housing, wherein the insulate housing is in an open status;
connecting a circuit unit to the piezoelectric unit, wherein the circuit unit connects to a connector, and wherein the connector is configured to electronically connect to one or more external electronic components; and
closing the insulate housing so that the insulate housing in a closed status accommodates the piezoelectric unit, the circuit unit and a part of the connector.

14. The method of claim 13, further comprising:
connecting the piezoelectric unit to a first side of a board of the insulate housing;
locating the circuit unit on a second side of the board of the insulate housing; and
connecting the circuit unit to the piezoelectric unit through the board.

15. The method of claim 14, further comprising:
filling the second side of the board with non-conductive materials to cover the second side of the board, the circuit unit and the part of the connector; and
connecting a faceplate to the board of the insulate housing to cover the first side of the board and the piezoelectric unit.
